Europäisches Patentamt

European Patent Office

Office européen des brevets

(11) Veröffentlichungsnummer: **0 356 717**
**A2**

# (12) EUROPÄISCHE PATENTANMELDUNG

(21) Anmeldenummer: 89113964.4

(22) Anmeldetag: 28.07.89

(51) Int. Cl.5: **H05K 3/00**

(30) Priorität: 02.09.88 DE 8811092 U

(43) Veröffentlichungstag der Anmeldung:
**07.03.90 Patentblatt 90/10**

(84) Benannte Vertragsstaaten:
**AT BE CH DE ES FR GB IT LI NL SE**

(71) Anmelder: **Hans Kolbe & Co.**
**Bodenburger Strasse 32**
**D-3202 Bad Salzdetfurth(DE)**

(72) Erfinder: **Ben-Mizzian-Palma, Manfred**
**Posener Str. 4d**
**D-3370 Seesen(DE)**
Erfinder: **Henkel,Ewald**
**Harzstr. 3**
**D- 3370 Seesen(DE)**

(74) Vertreter: **Sobisch, Peter, Dipl.-Ing. et al**
**Patentanwälte Dipl.-Inge. Röse, Kosel &**
**Sobisch Odastrasse 4a Postfach 129**
**D-3353 Bad Gandersheim 1(DE)**

(54) **Auflagetisch für Bohrpakete aus Leiterplatten.**

(57) Bei der Herstellung der Bohrbilder elektrischer Leiterplatten werden diese zunächst zwecks Bildung eines Bohrpaketes gestapelt, welches Bohrpaket zwecks Zentrierung auf einer, der Erstellung des Bohrbildes dienenden Bohrmaschine verstiftet wird. Zur Vereinfachung des Herstellvorgangs, insbesondere zur Vermeidung der Verwendung verstifteter Bohrpakete wird ein Auflagetisch mit einer Spanneinrichtung (1) vorgeschlagen, welche Spanneinrichtung (1) aus vertikal gegenüber dem Auflagetisch und in der Ebene desselben verschiebbar angeordneten Pratzen (5) einerseits und aus vertikal gegenüber dem Auflagetisch verschiebbaren, in dessen Ebene hingegen festen Anschlagpratzen (8) besteht, wobei die erstgenannten Pratzen (5) und die Anschlagpratzen (8) entlang wenigstens einer, der Kontur eines Bohrpakets in der Ebene des Auflagetisches nachgebildeten Linie angeordnet sind. Das System von beweglichen Pratzen (5) und Anschlagpratzen (8) gewährleistet ein genaues Ausrichten der einzelnen gestapelten Materialzuschnitte eines Bohrpakets sowie deren unverrückbare Fixierung zwecks Erstellung des genannten Bohrbildes.

Fig 1

## Auflagetisch für Bohrpakete aus Leiterplatten

Die Erfindung bezieht sich auf einen Auflagetisch entsprechend dem Oberbegriff des Anspruchs 1.

Die Herstellung von Bohrbildern bei elektrischen Leiterplatten geschieht bekanntlich aus Kostengründen derart, daß aus diesen Platten sogenannte Bohrpakete gebildet werden, innerhalb welcher werkstofflich unterschiedlich beschaffene, untereinander geometrisch jedoch gleiche Zuschnitte geschichtet angeordnet sind. Diese Bohrpakete werden einem einheitlichen Bohrvorgang mit dem Ziel der Einbringung des Bohrbildes unterzogen.

Die Bildung dieser Bohrpakete, deren Zuschnitte aus Holz, Kupfer, Aluminium oder auch weiteren Materialien bestehen, geschieht derart, daß diese Zuschnitte zunächst manuell unterschiedlichen Stapeln entnommen und in definierter Weise übereinander geschichtet werden. Zur sicheren Handhabung dieses Stapels, insbesondere zur exakten Anbringung des Bohrbildes auf sämtlichen Leiterplatten wird dieser anschließend in einem halbautomatisch arbeitenden Bohr- und Verstiftautomat verstiftet, d.h. es werden insbesondere an Randbereich des Stapels mehrere, sämtliche Zuschnitte durchdringende Bohrungen in diese eingebracht, in welche Stifte eingepaßt werden, welche sämtliche Zuschnitte durchdringen und aus dem Stapel herausragen. Durch diese Stifte werden die einzelnen Zuschnitte eines Stapels in seitlicher Richtung unverrückbar festgelegt und es wird darüber hinaus der Stapel mittels der aus diesem herausragenden Enden der Stifte auf einem Auflagetisch einer zur Erstellung des Bohrbildes dienenden Bohrmaschine leicht zentrierbar.

Im Rahmen der Herstellung eines Bohrbildes bei derartigen Bohrpaketen, beginnend mit der Stapelbildung und endend mit der Erstellung des fertigen Bohrbildes ist der obige Verfahrensschritt der Verstiftung mit einem nicht unbeträchtlichen Anteil an manuellen Tätigkeiten verbunden. Hinzu tritt der Investitionsaufwand für die Bereitstellung des genannten Bohr- und Verstiftungsautomaten sowie weitere Transportwege von diesem zu der, das Bohrbild erstellenden Bohrmaschine.

Es ist die Aufgabe der Erfindung, einen Auflagetisch der eingangs bezeichneten Gattung zu entwerfen, der einer, der Erstellung eines Bohrbildes dienenden Bohrmaschine zugeordnet ist und bei welchem sich der Einsatz verstifteter Bohrpakete erübrigt, so daß in der oben beschriebenen Reihenfolge von Verfahrensschritten der Verstiftungsvorgang entfällt. Gelöst ist diese Aufgabe bei einem gattungsgemäßen Auflagetisch durch die Merkmale des Kennzeichnungsteils des Anspruchs 1.

Erfindungswesentlich sind somit zusätzliche Anschlagpratzen, welche sowohl der exakten Ausrichtung der einzelnen Zuschnitte eines Stapels als auch dem festen, unverrückbaren Einspannen derselben während der Anbringung des Bohrbildes dienen. Die Stapelbildung kann somit auf einem der Bohrmaschine zugeordneten Auflagetisch unmittelbar erfolgen und es kann hierbei der Bohrvorgang an unverstifteten Bohrpaketen vorgenommen werden.

Bekannt sind bisher lediglich solche Auflagetische, die mit relativ zu dem Bohrpaket, beispielsweise senkrecht zu dessen rechteckiger Grundgestalt hin bewegbaren Pratzen versehen sind, welche entlang der Kontur des Bohrpaketes angeordnet sind, welche jedoch keine definierten Anschlagflächen zur exakten Ausrichtung der Zuschnitte eines Stapels aufweisen und nicht dazu bestimmt sind, um die Zuschnitte eines Stapels in einer unverrückbaren Position relativ zueinander sowie zu dem Auflagetisch zu halten.

Die genannten Anschlagpratzen sowie die übrigen beweglichen Pratzen sind entlang der Umrandung des Bohrpakets angeordnet, welche Anordnung somit auf die charakteristischen Konturformen von Bohrpaketen abgestimmt ist. Um eine Vielzahl von Bohrpaketformaten auf dem Auflagetisch bearbeiten zu können, befinden sich auf diesem stets mehrere derartiger Anordnungen. Wesentlich ist darüber hinaus, daß die Anschlagpratzen mit Mitteln zum Übergreifen eines Bohrpakets ausgerüstet sind, nämlich Klemmbacken und mit einem Antrieb in Verbindung stehen, über welchen die erforderliche Anpreßkraft auf das Bohrpaket übertragbar ist. Dieser Antrieb kann beispielsweise durch eine pneumatisch betätigte Kolben-Zylinder-Einheit gebildet sein - es kommt auch ein elektrischer Antrieb in Betracht. Mithin besteht die Möglichkeit, das Bohrpaket unmittelbar auf dem Auflagetisch zu bilden, indem dessen einzelne Zuschnitte gegen die Anschlagflächen der Anschlagpratzen gelegt werden, welches durch eine Bewegung der beweglichen Pratzen unterstützt werden kann, wobei anschließend durch Betätigung der genannten Antriebe der Anschlagpratzen das auf diese Weise gebildete Bohrpaket fest und unverrückbar auf dem Auflagetisch arretiert ist und unmittelbar das genannte Bohrbild erstellt werden kann. Die den beweglichen Pratzen zugeordneten Antriebe können hierbei wie an sich bekannt ausgebildet sein.

Aufgrund der Merkmale der Ansprüche 2 und 3 ist der Auflagetisch in einfacher Weise an unterschiedliche Rechteckformate der Bohrpakete anpaßbar. Die Anordnung der Anschlagpratzen bzw. deren Anschlagflächen ermöglicht ein rasches manuelles Anlegen der einzelnen Zuschnitte, wobei die Anordnung der beweglichen Pratzen, insbesondere die Richtung deren Beweglichkeit dazu beiträgt, den Stapel gegen die Anschlagflächen zu halten. Die Ausgestaltung der Antriebe der Anschlagpratzen entsprechend den Merkmalen der Ansprüche 5 und 6 ist konstruktiv einfach realisierbar und sichert darüber hinaus bei Ausfall der Versorgung mit dem jeweiligen Druckmedium ein Halten der Bohrpakete in der jeweiligen Arbeitsstellung. Letzteres Halten wird durch die Kraft mechanischer Federn, z. B. Schraubenfedern übernommen. Die einzelnen Anschlagpratzen werden durch einen unmittelbar an dem genannten Kolben befestigten Stößel angebrachten Spannkopf gebildet, welcher mit Hinblick auf die Klemmung eines Bohrpakets eine besondere Ausgestaltung erfahren hat. Letztere betrifft unter anderem die genannte Klemmbacke, welche zum Übergreifen des Bohrpaketes sowie zum Pressen desselben gegen die Ebene des Auflagetisches bestimmt ist.

Durch die Führung des Stößels gemäß den Merkmalen des Anspruchs 7 in zueinander koaxialen Bohrungen des Auflagetisches sowie des genannten Ansatzbauteils ist eine sehr genaue Position der jeweiligen Anschlagfläche gegeben. Der Stößel ist in den genannten Bohrungen mit den an sich bekannten Mitteln verdrehungsfrei aufgenommen.

Auch die Ausgestaltung des Spannkopfes entsprechend den Merkmalen des Anspruchs 8 stellt eine sehr einfache und insbesondere robuste Ausführungsform dar.

Die Erfindung wird im folgenden unter Bezugnahme auf das in den Zeichnungen dargestellte Ausführungsbeispiel näher erläutert werden. Es zeigen:

Fig. 1 eine Draufsicht auf die erfindungsgemäße Spannvorrichtung;

Fig. 2 eine Teilansicht einer Schnittdarstellung in einer Ebene II-II der Fig. 1.

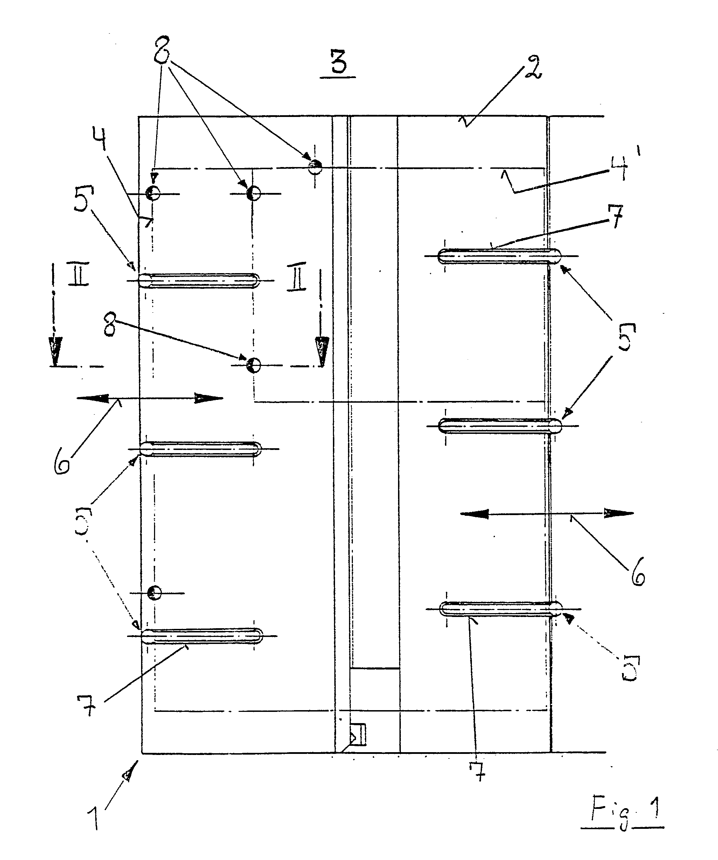

Mit 1 ist in Fig. 1 die erfindungsgemäße Spannvorrichtung in ihrer Gesamtheit bezeichnet. Diese besteht hiernach aus einem rechteckigen, horizontal angeordneten Auflagetisch bzw. einer Grundplatte 2, die zur Auflage von Leiterplattenpaketen bestimmt ist, wobei der Grundplatte 2 eine zeichnerisch nicht dargestellte, an der Stelle 3 befindliche ein- oder mehrspindlige Bohrmaschine zugeordnet ist, deren Bohrwerkzeug in an sich bekannter Weise CNC-oder DNC-gesteuert im wesentlichen an jedem Punkt innerhalb der Grundplatte 2 zum Einsatz gebracht werden kann.

Mit 4 ist in strich-punktierter Darstellung lediglich beispielhaft ein Leiterplattenpaket bezeichnet, welches in an sich bekannter Weise aus einer Übereinanderschichtung von aus unterschiedlichen Materialien, geometrisch in der Fläche identischen, aus Holz, Kupfer und/oder weiteren Materialien ausgebildeten Zuschnitten besteht. In dieses, auf die Spannvorrichtung 1 gebrachte Leiterplattenpaket 4 wird mittels der erwähnten, nicht dargestellten Bohrmaschine ein an eine bestimmte Schaltung angepaßtes Bohrbild eingebracht.

Mit 5 sind Pratzen bezeichnet, welche eine in der Zeichnung nicht näher dargestellten pilzförmigen Haltebacke aufweisen, welche zum übergreifen des Leiterpaketes 4 bestimmt ist und durch welche dieses in der Ebene der Grundplatte 2 gehalten wird.

Die Grundplatte 2 ist derart bemessen, daß sämtliche üblichen Größen von Leiterplattenpaketen 4 auflagerbar sind. Es sind in der Zeichnung sechs Pratzen 5 erkennbar, welche in gleichmäßiger Verteilung entlang den Längsseiten der rechteckförmigen Grundplatte 2 angeordnet sind. Die Pratzen 5 sind jeweils in Richtung der Pfeile 6 in der Ebene der Grundplatte 2 verfahrbar und zu diesem Zweck in Schlitzen 7 der Grundplatte 2 aufgenommen. Es sind die Pratzen bzw. deren Haltebacken darüber hinaus aus der Ebene der Grundplatte 2 zwecks Übergreifens eines Leiterplattenpaketes 4 ausfahrbar. Sämtlichen Bewegungen der Pratzen 5, und zwar sowohl in Richtung der Pfeile 6 als auch senkrecht zur Ebene der Grundplatte 2 sind Antriebe, vorzugsweise pneumatische Antriebe zugeordnet. Die Verschiebbarkeit der Pratzen 5 in Richtung der Pfeile 6 bzw. die Bemessung der Schlitze 7 ist derart vorgenommen, daß eine Anpassungsfähigkeit der erfindungsgemäßen Spannvorrichtung an die üblichen Formate der Leiterplattenpakete gegeben ist. Es dienen die Pratzen 5 jedoch nur einer vergleichsweise groben Ausrichtung der einzelnen Zuschnitte des Leiterplattenpaketes und keineswegs der exakten Ausrichtung bzw. Positionierung derselben relativ der an der Stelle 3 befindlichen Bohrmaschine.

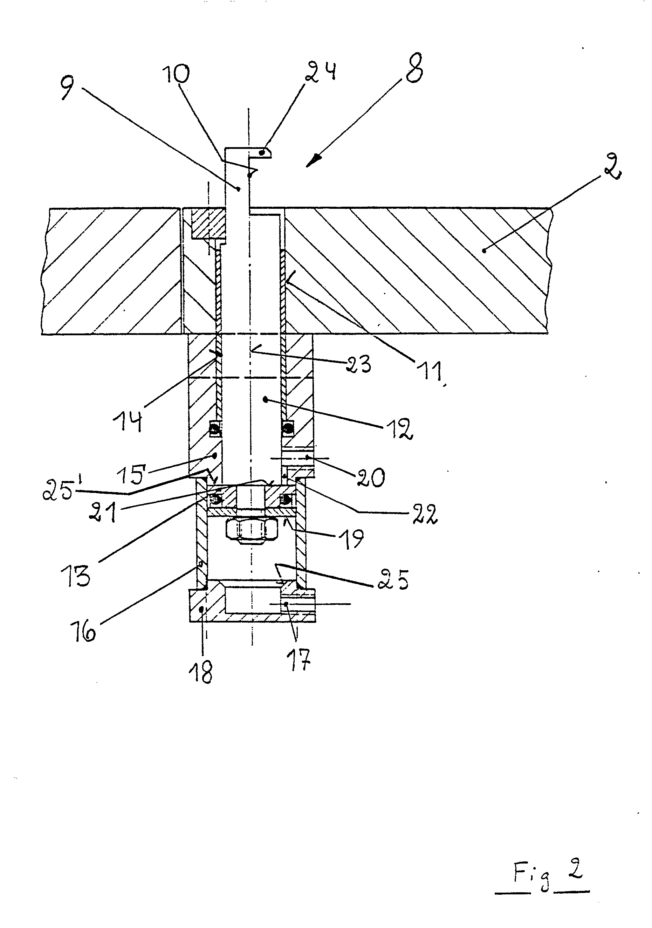

Mit 8 sind Anschlagpratzen bezeichnet, deren genaue Beschaffenheit im folgenden unter Bezugnahme auf Fig. 2 noch genauer beschrieben wird, welche lediglich senkrecht zur Ebene der Grundplatte 2 verschiebbar sind. Diese Anschlagpratzen 8 dienen der exakten Positionierung sowie vertikalen Ausrichtung der ein Leiterplattenpaket bildenden Zuschnitte und darüber hinaus deren unverrückbarer Fixierung auf der Grundplatte 2. Die mittels der Anschlagpratzen 8 eingespannten Zuschnitte eines Leiterplattenpaketes befinden sich somit in einer exakten seitlichen Ausrichtung zueinander. Die Anschlagpratzen 8 sind in der Grundplatte 2 derart angeordnet, daß ein Leiterplattenpaket stets von zwei, zueinander senkrecht verlaufenden Kanten her erfaßt werden kann. Die Anordnung der Anschlagpratzen 8 erfolgt darüber hinaus derart, daß sämtliche üblichen Formate der Leiterplattenpakete 4 erfaßbar sind. Lediglich beispielhaft zeigt die Fig. 1 in strichpunktierter Darstellung das größtmögliche Format eines Leiterplattenpaketes 4 und das kleinstmögliche Format eines Leiterplattenpaketes 4'.

Das in Fig. 2 gezeigte Ausführungsbeispiel eines Anschlagpratzens besteht aus einem, in der Ausfahrstellung aus der Ebene der Grundplatte 2 herausragenden Spannkopf 9, welcher mit einer sich vertikal erstreckenden ebenen Anschlagfläche 10 versehen ist. Die Anschlagflächen 10 sämtlicher Anschlagpratzen 8 sind derart angeordnet, daß deren jeweilige Ebenen parallel zu zwei zueinander senkrechten Richtungen verlaufen, welche zwei zueinander senkrechten seitlichen Begrenzungsflächen eines Leiterplattenpaketes entsprechen.

Der Spannkopf 9 bildet das eine Ende eines unverdrehbar in einer Bohrung 11 der Grundplatte 2 aufgenommenen Stößels 12, an dessen anderem Ende ein Kolben 13 befestigt, hier angeschraubt ist. Der Stößel 12 ist außerhalb der Bohrung 11 in einer zu dieser koaxial verlaufenden Bohrung 14 eines an der Unterseite der Grundplatte 2 angebrachten Ansatzbauteils 15 geführt, wobei an dem genannten Ansatzbauteil 15 ein den Kolben 13 aufnehmender Zylinder 16 befestigt ist. Eine mit einer Anschlußbohrung 17 für die Führung eines Druckmediums versehene Kopfplatte 18 bildet den, dem Ansatzbauteil 15 abgekehrten stirnseitigen Abschluß des Zylinders 16. Über die Anschlußbohrung 17 ist die eine Seite 19 des genannten Kolbens mit einem Druckmedium beaufschlagbar, wohingegen über eine weitere, in dem Ansatzbauteil 15 angeordnete, radial zu der Bohrung 14 verlaufende Anschlußbohrung 20 die andere Seite 21 des Kolbens 13 beaufschlagbar ist.

Die Zeichnungsfigur 2 zeigt den Stößel 12 in seiner ausgefahrenen Position, in welcher die Verbindung zwischen der Anschlußbohrung 20 und der genannten Seite 21 und damit deren Druckbeaufschlagung über eine achsparallel verlaufende Nut 22 erfolgt. Die Mittelachse 23 des Stößels 12 verläuft an dessen oberem Ende innerhalb der Anschlagfläche 10, welche ihrerseits an ihrem äußeren, d.h. oberen Ende in eine sich parallel zur Ebene der Grundplatte 2 erstreckende Klemmbacke 24 übergeht, welch letztere zum Übergreifen eines Leiterplattenpaketes bestimmt ist.

Wie sich aus obigem ergibt, ist der Kolben 13 beidseitig mit einem Druckmedium beaufschlagbar. Mittels einer zeichnerisch nicht näher dargestellten Feder wird der Kolben jedoch in Richtung auf die andere, der in Fig. 2 gegenüberliegenden Endstellung gelegene Stellung gedrängt, so daß ein Ausfahren des Stößels 12 entgegen der Wirkungsrichtung dieser Feder erfolgt. Hiermit wird erreicht, daß eine laufende Bearbeitung eines mittels der Klemmbacken 24 gehaltenen Leiterplattenpaketes auch bei Ausfall der Druckmittelversorgung nicht

beeinträchtigt wird. Es ist demzufolge die Feder derart bemessen, daß auch in diesem Störungsfall eine einwandfreie und unverrückbare Fixierung des Leiterplattenpaketes gegenüber der Grundplatte 2 gegeben ist.

Die oben dargestellte Spannvorrichtung bringt beim Erstellen von Bohrbildern bei Leiterplattenpaketen gegenüber der bisherigen Arbeitsweise den Vorteil mit sich, daß ein Verstiften der Leiterplattenpakete zwecks Zentrierung und Fixierung der einzelnen übereinander liegenden Zuschnitte entfällt. Durch die Anschlagpratzen 8 in Verbindung mit den beweglichen Pratzen 5 wird nicht nur eine genaue Positionierung eines Leiterplattenpaketes auf der Grundplatte 2 erreicht, sondern auch eine zuverlässige und insbesondere genaue Ausrichtung der Zuschnitte zueinander. Die Zuschnitte sind darüber hinaus durch die Anschlagpratzen unverrückbar auf der Grundplatte gehalten, so daß ein vorgegebenes Bohrbild genau einhaltbar ist.

## Ansprüche

1. Auflagetisch mit Spanneinrichtung (1) zum Bilden von aus einzelnen, zumindest teilweise aus stofflich unterschiedlichen, plattenartigen, zueinander ausgerichteten und mit Hinblick auf die Erstellung eines Bohrbildes auf dem Auflagetisch festgelegten Materialzuschnitten bestehenden Bohrpaketen, wobei die Spanneinrichtung (1) zumindest aus vertikal gegenüber dem Auflagetisch und in der Ebene desselben verschiebbar angeordneten beweglichen Pratzen (5) besteht, dadurch gekennzeichnet, daß die Spanneinrichtung (1) ferner aus vertikal gegenüber dem Auflagetisch verschiebbaren, in der Ebene desselben hingegen festgelegten Anschlagpratzen (8) besteht, daß die beweglichen Pratzen (5) und die Anschlagpratzen (8) entlang wenigstens einer, der Kontur eines Bohrpakets in der Ebene des Auflagetisches nachgebildeten Linie auf dem Auflagetisch angeordnet sind, daß zumindest ein Teil der beweglichen Pratzen (5) den Anschlagpratzen (8) gegenüberliegend angeordnet ist, daß die Anschlagpratzen (8) mit zum Übergreifen zumindest eines Bohrpakets bestimmten, durch Verschiebung derselben senkrecht zur Ebene des Auflagetisches zur Anlage an das Bohrpaket bringbaren klemmbacken (24) versehen sind, daß die Anschlagpratzen (8) jeweils mit mindestens einer Anschlagfläche (10) für das Bohrpaket versehen sind und daß zumindest die Anschlagpratzen (8) mit einem, zur Aufbringung der erforderlichen, auf das Bohrpaket auszuübenden Haltekraft geeigneten Antrieb in Verbindung stehen.

2. Auflagetisch nach Anspruch 1, dadurch gekennzeichnet, daß die genannten Linien jeweils ein Rechteck bilden und daß die Anschlagflächen (10) der Anschlagpratzen (8) senkrecht zur Ebene des Auflagetisches und - in ihrer Projektion in der genannten Ebene - parallel zu zwei zueinander senkrechten Seiten des Rechteckes verlaufen.

3. Auflagetisch nach Anspruch 2, dadurch gekennzeichnet, daß die beweglichen Pratzen (5) senkrecht zu jeweils einer Seite des Rechteckes verschiebbar angeordnet sind und in an sich bekannter Weise mit zum Übergreifen zumindest eines Bohrpakets bestimmten, durch Verschiebung senkrecht zur Ebene des Auflagetisches zur Anlage an das Bohrpaket bringbaren Haltebacken versehen sind.

4. Auflagetisch nach einem der vorangegangenen Ansprüche 1 bis 3, dadurch gekennzeichnet, daß sowohl die beweglichen Pratzen (5) als auch die Anschlagpratzen (8) in der Ebene des Auflagetisches versenkbar angeordnet sind.

5. Auflagetisch nach einem der vorangegangenen Ansprüche 1 bis 4, dadurch gekennzeichnet, daß der den einzelnen Anschlagpratzen (8) zugeordnete Antrieb jeweils durch eine Kolben-Zylinder-Einheit gebildet wird, deren Kolben (13) vorzugsweise beidseitig beaufschlagbar ist und daß an dem Kolben (13) ein einen Spannkopf (9) sowie eine Klemmbacke (24) tragender Stößel (12) befestigt ist.

6. Auflagetisch nach Anspruch 5, dadurch gekennzeichnet, daß der Kolben (13) zwischen zwei, durch jeweils einen Anschlag definierten Grenzstellungen bewegbar ist, nämlich einer Ausfahr- und einer Einfahrstellung, daß der Kolben (13) mit einem, im wesentlichen in der einen Richtung wirkenden Federelement in Verbindung steht und daß diese Richtung die einwärts, d.h. auf die Einfahrstellung hin gerichtete Richtung ist.

7. Auflagetisch nach Anspruch 6, dadurch gekennzeichnet, daß ein den Kolben (13) aufnehmender Zylinder (16) über ein Ansatzbauteil (15) an der Unterseite des Auflagetisches befestigt ist, daß der Stößel (12) in zueinander koaxialen Bohrungen (11,14) des Auflagetisches sowie des Ansatzbauteils geführt ist, daß die Anschläge durch Ringflächen (25,25') einer am einen Ende des Zylinders angeordneten Kopfplatte (18) sowie eines am anderen Ende des Zylinders (16) befindlichen Endteils des Ansatzbauteils (15) gebildet werden und daß zur beidseitigen Beaufschlagung des Kolbens (13) Anschlußbohrungen (17,20) in der Kopfplatte (18) bzw. dem Ansatzbauteil (15) angeordnet sind.

8. Auflagetisch nach einem der vorangegangenen Ansprüche 5 bis 7, dadurch gekennzeichnet, daß der Stößel (12) als zylindrischer Körper ausgebildet ist und daß dessen Spannkopf (9) durch eine, die wenigstens eine Anschlagfläche (10) beinhaltende, durch die Klemmbacke (24) oberseitig überdeckte und seitlich offene Ausnehmung des genannten Körpers gebildet wird.

Fig. 1

Fig 2